# EUROPÄISCHE PATENTSCHRIFT

(11) **EP 0 393 224 B1**
(45) Veröffentlichungstag und Bekanntmachung des Hinweises auf die Patenterteilung: **16.02.1994**
(21) Anmeldenummer: 89107152.4
(22) Anmeldetag: 20.04.1989
(51) Int. Cl.: H02H 5/04, H03K 17/08, H04M 19/00

(54) **Schaltungsanordnung zur Temperaturüberwachung von in einem Halbleiterschaltkreis integrierten Leistungsschalttransistoren**
Circuitry for controlling the temperature of integrated power switching transistors in a semi-conductor circuit
Dispositif de contrôle de la température des transistors de puissance intégrés dans un circuit à semi-conducteurs

(43) Veröffentlichungstag der Anmeldung: 24.10.1990
(73) Patentinhaber: SIEMENS AKTIENGESELLSCHAFT, 80333 München (DE)
(72) Erfinder: Zitta, Heinz, Dipl.-Ing., A-9580 Drobollach (AT); Koroncai, Adam, Dipl.-Ing., A-9020 Klagenfurt (AT); Massoner, Johann, Dipl.-Ing., A-9500 Villach (AT)

(56) Entgegenhaltungen:
- DE-A- 2 710 762
- DE-A- 3 007 403
- US-A- 4 779 161
- DER ELEKTRONIKER, Nr. 12, 1985, Seiten 58-64, Frankfurt, DE; A. CLARK et al.: "Stromversorgungs-Bausteine für das ISDN"
- IEEE JOURNAL OF SOLID STATE CIRCUITS, Band SC-18, Nr. 6, Dezember 1983, Seiten 665-677, New York, USA; R.M. SIRSI et al.: "Integrated Electronic Subscriber Linte Interface Circuit with Ringing on Chip"

## Beschreibung

Die vorliegende Erfindung betrifft eine Schaltungsanordnung zur Temperaturüberwachung von in einem Halbleiterschaltkreis integrierten Leistungs-Schalttransistoren nach dem Oberbegriff des Patentanspruches 1.

Ein integrierter Schaltkreis, in dem mehrere Leistungs-Schalttransistoren in einem einzigen System integriert sind, ist beispielsweise ein integrierter Leistungsregler, der speziell zur Speisung von Zwei- und Vierdraht-Übertragungsleitungen in Telefonvermittlungsanlagen ausgelegt ist. Dabei wird die individuelle Leistungsversorgung und -regelung über jeweils einen Leistungs-Schalttransistor vorgenommen, so daß bis zu vier derartige Transistoren in einem System integriert sind.

In einem derartigen integrierten Schaltkreis müssen die Leistungs-Schalttransistoren gegen thermische Überlastung geschützt und bei Überschreiten einer vorgegebenen Temperatur des Schaltkreissystems abgeschaltet werden.

Dazu ist es bekannt, bei Erreichen einer vorgegebenen Temperatur des Schaltkreissystems ein Abschaltsignal zu erzeugen und unabhängig davon, welcher Leistungs-Schalttransistor für die Temperaturerhöhung damit die thermische Überlastung auslösend war, alle Leistungs-Schalttransistoren abzuschalten. Dies ist jedoch nicht immer erforderlich, da es ausreichend wäre, lediglich den Leistungs-Schalttransistor und die durch ihn versorgte Leitung abzuschalten, der für die thermische Überlastung verantwortlich war. Diese Lösung ist beispielsweise in einem integrierten Schaltkreis der Fa. Advanced Micro Devices mit der Typenbezeichnung Am 7938 realisiert
Eine ähnliche Lösung ist aus der US-A-4779 161 bekannt, bei der als Temperatursensor ein Bipolartransistor dient, der von einer einem vorgegebenen Temperaturwert entsprechenden Referenz gesteuert wird. Bei Erreichen des vorgegebenen Temperaturwertes beginnt der Bipolartransistor zu leiten und dadurch den Steuerstrom des zugeordneten Leistungstransistors zu verringern. Die anderen Leistungstransistoren werden solange nicht beeinflußt wie ihre Temperatur unterhalb des vorgegebenen Temperaturwertes liegt.

Der vorliegenden Erfindung liegt die Aufgabe zugrunde, eine Schaltungsanordnung der in Rede stehenden Art anzugeben, mit der es möglich ist, lediglich den bzw. die für die Temperaturüberlastung verantwortlichen Leistungs-Schalttransistor bzw. -transistoren abzuschalten und alle anderen Leistungs-Schalttransistoren auch dann eingeschaltet zu halten, wenn das Schaltkreissystem über die Stelle hinaus, an der die Temperaturerhöhung zunächst aufgetreten ist, diese erhöhte Temperatur insgesamt angenommen hat.

Diese Aufgabe wird bei einer Schaltungsanordnung der eingangs genannten Art erfindungsgemäß durch die Merkmale des kennzeichnenden Teils des Patentanspruches 1 gelöst.

Weiterbildungen der Erfindung sind Gegenstand von Unteransprüchen.

Die Erfindung wird im folgenden anhand von in den FIG der Zeichnung dargestellten Ausführungsbeispielen näher erläutert. Es zeigt:
- FIG 1: ein schematisches Schaltbild einer Ausführungsform der erfindungsgemäßen Schaltungsanordnung; und
- FIG 2: ein Teilschaltbild eines als Emitterfolger-Transistorstufe ausgebildeten Temperatursensors mit nachgeschalteter Vergleichsstufe.

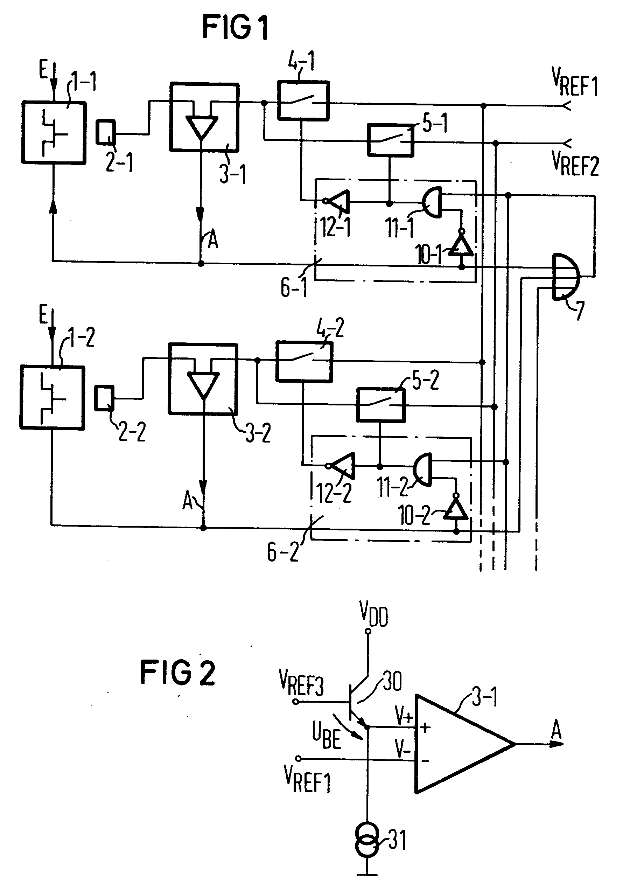

In der Schaltungsanordnung nach FIG 1 sind durch ein Einschaltsignal E durchschaltbare Leistungs-Schalttransistoren 1-1 und 1-2 vorgesehen, bei denen es sich um gegen thermische Überlastung zu schützende Elemente handelt und deren Temperatur zu überwachen ist. Es sei darauf hingewiesen, daß in FIG 1 lediglich zwei Leistungs-Schalttransistoren schematisch dargestellt sind. In einer praktischen Ausführungsform können auch mehr Leistungs-Schalttransistoren, beispielsweise etwa vier derartige Elemente vorgesehen sein, wenn es sich beispielsweise, wie oben ausgeführt, um einen integrierten Schaltkreis in Form eines Leistungsreglers für eine Vierdrahtleitung einer Fernsprechvermittlungsanlage handelt. Gleiches gilt dann ebenso für die im folgenden noch zu beschreibenden weiteren Komponenten der Schaltungsanordnung nach FIG 1.

Es sei weiterhin darauf hingewiesen, daß der integrierte Schaltkreis in Bipolar-, MOS- oder BICMOS-Technologie ausgeführt sein kann. Auch die Leistungs-Schalttransistoren 1-1,1-2 können daher Bipolar- oder MOS-Transistoren sein.

Den Transistoren 1-1,1-2 ist jeweils ein eigener Temperatursensor 2-1,2-2 eng benachbart zugeordnet, wobei es sich gemäß einer besonderen Ausführungsform nach FIG 2 jeweils um eine als Emitterfolger geschaltete Transistorstufe handeln kann, die mit ihrer Basis an einer (dritten) Referenz V_{REF3} liegt.

Diese Temperatursensoren 2-1,2-2 sind an jeweils einen Eingang einer Vergleichsstufe 3-1,3-2 angekoppelt, die mit einem weiteren Eingang an eine erste Referenz V_{REF1} angekoppelt sind. Diese Vergleichsstufen 3-1,3-2 können in an sich bekannter Weise durch eine Operationsverstärkerstufe gebildet sein. Die Referenz V_{REF1} entspricht einem ersten vorgegebenen Temperaturwert von beispielsweise 130^{°}C. Diese Referenz V_{REF1} ist über jeweils einen ersten Umschalter 4-1,4-2 auf die Vergleichsstufen 3-1,3-2 geführt.

Der Ausgang der jeweiligen Vergleichsstufe 3-1,3-2 ist einerseits auf den jeweiligen Leistungs-Schalttransistor 1-1,1-2 und andererseits auf eine Logik geführt, die durch jeweils eine Gatterstufe 6-1,6-2 sowie ein gemeinsames ODER-Gatter 7 gebildet wird. Die Gatterstufen 6-1,6-2 enthalten ihrerseits jeweils einen Inverter 10-1,10-2, der mit seinem Eingang am Ausgang der jeweiligen Vergleichsstufe 3-1,3-2 und mit seinem Ausgang an einem Eingang eines UND-Gatters 11-1,11-2 liegt. Das jeweilige UND-Gatter 11-1,11-2 liegt mit einem weiteren Eingang am Ausgang des ODER-Gatters 7. Der Ausgang des jeweiligen UND-Gatters 11-1,11-2 ist auf den Eingang eines weiteren Inverters 12-1,12-2 geführt, dessen Ausgang auf den jeweiligen Umschalter 4-1,4-2 geführt ist, um diesen in Abhängigkeit vom Ausgangssignal dieses weiteren Inverters umzuschalten. Schließlich liegt der Ausgang des jeweiligen UND-Gatters 11-1,11-2 an einem weiteren Umschalter 5-1,5-2, über den eine zweite einer zweiten vorgegebenen Temperatur entsprechende Referenz V_{REF2} auf den Eingang der Vergleichsstufen 3-1,3-2 geführt ist, auf den auch die erste Referenz V_{REF1} geführt ist.

Die zweite Referenz V_{REF2} entspricht dabei einem zweiten vorgegebenen Temperaturwert, der größer als der erste vorgegebene Temperaturwert und beispielsweise gleich 150^{°}C ist.

Die Wirkungsweise der vorstehend beschriebenen Schaltungsanordnung ist die folgende:
Es sei zunächst angenommen, daß eine thermische Überlastung der Leistungs-Schalttransistoren 1-1,1-2 nicht gegeben ist und die Temperatur des Schaltkreissystems unterhalb der der ersten Referenz V_{REF1} entsprechenden ersten vorgegebenen Temperatur liegt. Die von den Temperaturfühlern 2-1,2-2 abgegebene Spannung liegt dann unterhalb der Referenzspannung V_{REF1} und die Transistoren 1-1,1-2 sind durchgeschaltet.

Es sei nun angenommen, daß beispielsweise der Leistungs-Schalttransistor 1-1 überlastet wird und in seinem Bereich im integrierten Schaltkreissystem daher eine Temperaturerhöhung auftritt. Diese Temperaturerhöhung wird durch den Temperatursensor 2-1 erfaßt und als ein Eingangssignal in die Vergleichsstufe 3-1 eingespeist. Übersteigt die Spannung am Temperatursensor 2-1 die erste Referenzspannung V_{REF1}, so schaltet die Vergleichsstufe 3-1 um und liefert ein Ausgangssignal A, das als Abschaltsignal auf den Leistungs-Schalttransistor 1-1 gegeben wird, so daß dieser abgeschaltet wird. Ein wesentliches erfindungsgemäßes Merkmal ist es also, daß lediglich eine Abschaltung desjenigen Leistungs-Schalttransistors erfolgt, in dem durch Überlastung eine Temperaturerhöhung auftritt.

Im folgenden wird die Wirkungsweise der durch die Gatterstufen 6-1,6-2 und das ODER-Gatter 7 gebildeten Logik beschrieben. Es sei zunächst wiederum davon ausgegangen, daß eine thermische Überlastung im integrierten Schaltkreis nicht gegeben ist. Die Vergleichsstufen 3-1,3-2 haben also nicht umgeschaltet, so daß ein Abschaltsignal A nicht vorhanden ist. Das dann am Ausgang der Vergleichsstufen 3-1,3-2 stehende Signal kann als ein Signal mit tiefem Pegel interpretiert werden. Dieses Signal mit tiefem Pegel wird sowohl in den Eingang der Inverter 1-1,1-2 in den Gatterstufen 6-1,6-2 sowie in jeweils einen Eingang des ODER-Gatters 7 eingespeist. Durch die invertierende Wirkung des jeweiligen Inverters 10-1,10-2 wird dieses Signal mit tiefem Pegel als Signal mit hohem Pegel in einen Eingang des jeweiligen UND-Gatters 11-1,11-2 eingespeist, während es über das ODER-Gatter 7 als Signal mit tiefem Pegel in den weiteren Eingang des jeweiligen UND-Gatters 11-1,11-2 eingespeist wird. Die UND-Gatter 11-1,11-2 liefern dann ebenfalls jeweils ein Signal mit tiefem Pegel, das durch die Wirkung des jeweiligen weiteren Inverters 12-1,12-2 in den Gatterstufen 6-1,6-2 als Signal mit hohem Pegel auf die Umschalter 4-1,4-2 gegeben wird. Die weiteren Umschalter 5-1,5-2 erhalten das Signal mit tiefem Pegel am Ausgang der UND-Gatter 1-1,1-2. Bei dieser Signalkonfiguration werden die Umschalter 4-1,4-2 derart umgeschaltet, daß die erste Referenz V_{REF1} auf die Vergleichsstufen 3-1,3-2 gekoppelt wird. Da die Umschalter 5-1,5-2 vom Ausgang der UND-Gatter 11-1,11-2 ein Signal mit tiefem Pegel erhalten, bleibt die zweite Referenz V_{REF2} von den Vergleichsstufen 3-1,3-2 abgeschaltet.

Liefert nun im oben bereits erläuterten Sinne eine Vergleichsstufe, beispielsweise die Vergleichsstufe 3-1 ein Abschaltsignal A, das als Signal mit hohem Pegel interpretiert werden kann, so kehren sich an den beiden Eingängen des zugehörigen UND-Gatters 11-1 die Signalpegel um, so daß am Ausgang des UND-Gatters 11-1 und am Ausgang des Inverters 12-1 die Signalpegel erhalten bleiben, d.h. über den Umschalter 4-1 wird weiterhin die erste Referenz V_{REF1} auf die Vergleichsstufe 3-1 gekoppelt.

In der Gatterstufe 6-2 treten jedoch nun solche Pegelverhältnisse der Signale auf, daß durch Umschaltung des Umschalters 4-2 die erste Referenz V_{REF1} von der Vergleichsstufe 3-2 abgekoppelt und über den Umschalter 5-2 die zweite Referenz V_{REF2} auf die Vergleichsstufe 3-2 gekoppelt wird. Da nämlich der Leistungs-Schalttransistor 1-2 als nicht thermisch überlastet angenommen ist, verbleibt am Ausgang der Vergleichsstufe 3-2 ein Signal mit tiefem Pegel, das über den Inverter 10-2 als Signal mit hohem Pegel in den einen Eingang des UND-Gatters 12-2 eingespeist wird. Wie vorstehend bereits erläutert, steht jedoch nunmehr aufgrund der Umschaltung der Vergleichsstufe 3-1 am Ausgang des ODER-Gatters 7 und damit am anderen Eingang des UND-Gatters 11-2 ein Signal mit hohem Pegel, so daß nunmehr am Ausgang dieses UND-Gatters 11-2 ein Signal mit hohem Pegel und entsprechend am Ausgang des Inverters 12-2 ein Signal mit tiefem Pegel steht, woraus die vorgenannten Schaltstellungen der Umschalter 4-2 und 5-2 resultieren. Selbst wenn sich also die durch die thermische Überlastung des Leistungs-Schalttransistors 1-1 bedingte erhöhte Temperatur entsprechend der ersten Referenz V_{REF1} über das gesamte Schaltkreissystem ausgebreitet hat, bleiben dennoch die weiteren Leistungs-Schalttransistoren eingeschaltet, solange nicht die durch die zweite Referenz V_{REF2} festgelegte höhere Temperatur erreicht ist. Da die thermische Zeitkonstante des Systems auf jeden Fall größer als die elektrische Umschaltzeitkonstante ist, sind die erläuterten Schaltverhältnisse auf jeden Fall gewährleistet.

Gemäß FIG 2 können die Temperatursensoren 2-1,2-2 nach FIG 1 durch jeweils eine als Emitterfolger geschaltete und mit 30 bezeichnete Transistorstufe gebildet werden, in deren Emitterzweig eine Stromquelle 31 liegt und die von einer Versorgungsspannung V_{DD} gespeist wird. Diese Transistorstufe wird an ihrer Basis mit einer dritten Referenzspannung V_{REF3} gespeist. Ihre Basis-Emitter-Spannung U_{BE} stellt die temperaturabhängige Spannung dar, die als Spannung V+ in den nicht invertierenden Eingang einer Vergleichsstufe, beispielsweise der Vergleichsstufe 3-1 gemäß FIG 1 eingespeist wird. In den nicht invertierenden Eingang wird die erste Referenzspannung V_{REF1} (bzw. die zweite Referenzspannung V_{REF2}) als Spannung V- eingespeist.

Liegt die Temperatur zunächst noch unterhalb der durch die erste Referenz V_{REF1} vorgegebenen Temperatur, so ist die Spannung V+ kleiner als die Spannung V-, so daß am Ausgang der Vergleichsstufe 3-1 das Signal A mit tiefem Pegel steht.

Steigt die Temperatur, so sinkt die Basis-Emitter-Spannung U_{BE} des Transistors 30 und damit steigt die Spannung V+, bis oberhalb der Referenz V_{REF1} ein Zustand erreicht wird, bei dem die Spannung V+ größer als die Spannung V- ist, so daß die Vergleichsstufe 3-1 umschaltet und das Signal A einen hohen Pegel annimmt.

## Patentansprüche

1. Schaltungsanordnung zur Temperaturüberwachung, mit in einem Halbleiterschaltkreis integrierten Leistungs-Schalttransistorren (1-1,1-2,...), bei der die Schaltkreis-Temperatur zu deren Überlastungsschutz durch Temperatursensoren erfaßt wird und bei Überschreiten eines vorgegebenen Temperaturwertes eine Schalttransistor-Abschaltung erfolgt, wobei jeweils ein Temperatursensor (2-1,2-2,...) jeweils einem Leistungs-Schalttransistor (1-1,1-2,...) zugeordnet ist und das Temperatursensor-Ausgangssignal mit einer ersten einem ersten vorgegebenen Temperaturwert entsprechenden ersten Referenz (V_{REF1}) verglichen und nur der ihr zugeordnete Leistungs-Schalttransistor (1-1,1-2, ...) bei Erreichen des ersten vorgegebenen Temperaturwertes abgeschaltet wird, **gekennzeichnet durch** jeweils eine an jeweils einen Temperatursensor (2-1,2-2,...) angekoppelte Vergleichsstufe (3-1,3-2...) und durch eine an die Vergleichsstufen (3-1,3-2,...) angekoppelte Logik (6-1,6-2, ...,7), welche bei Erreichen des ersten vorgegebenen Temperaturwertes durch einen Leistungs-Schalttransistor (beispielsweise 1-1) und dessen Abschaltung die Vergleichsstufen (3-2,...) aller anderen Leistungs-Schalttransistoren (1-2,...) von der dem ersten vorgegebenen Temperaturwert entsprechenden Referenz (V_{REF1}) auf eine einem zweiten vorgegebenen, gegenüber dem ersten vorgegebenen Temperaturwert höheren Temperaturwert entsprechende zweite Referenz (V_{REF2}) umschaltet.

2. Schaltungsanordnung nach Anspruch 1, **dadurch gekennzeichnet,** daß als Temperatursensoren (2-1,2-2,...) als Emitterfolger geschaltete an einer dritten Referenz (V_{REF3}) liegende Transistorstufen vorgesehen sind.

3. Schaltungsanordnung nach Anspruch 1 und/oder 2, **dadurch gekennzeichnet,** daß die Logik (6-1,6-2,...,7) durch
jeweils eine jeweils einem Leistungs-Schalttransistor 1-1,1-2,...) zugeordnete Gatterstufe (6-1,6-2,...)
die einen an dem Eingang der zugehörigen Vergleichsstufe (3-1,3-2,...) angekoppelten ersten Inverter (10-1,10-2,...) ein mit einem Eingang an den Ausgang des ersten Inverters (10-1,10-2,...) angekoppeltes UND-Gatter (11-1,11-2,...) sowie einen an den Ausgang des UND-Gatters (11-1,11-2,...) angekoppelten zweiten Inverter (12-1,12-2,...) enthält, sowie ein ODER-Gatter (7), das mit jeweils einem Eingang an den Ausgang jeweils einer Vergleichsstufe (3-1,3-2,...) und mit seinem Ausgang an jeweils einen weiteren Eingang des UND-Gatters (11-1,11-2,...) der Gatterstufen (6-1,6-2,...) angekoppelt ist,
gebildet ist.

4. Schaltungsanordnung nach Anspruch 3, **dadurch gekennzeichnet,** daß der Ausgang des zweiten Inverters (12-1,12-2,...) an jeweils einen die erste Referenz (V_{REF1}) auf die jeweilige Vergleichsstufe (3-1,3-2,...) koppelnden ersten Umschalter (4-1,4-2,...) und der Ausgang des UND Gatters (11-1,11-2,...) der jeweiligen Gatterstufe (6-1,6-2,...) an jeweils einen die zweite Referenz (V_{REF2}) auf die jeweilige Vergleichsstufe (3-1,3-2,...) koppelnden zweiten Umschalter (5-1,5-2,...) gekoppelt ist.

5. Schaltungsanordnung nach einem der vorhergehenden Ansprüche, **dadurch gekennzeichnet,** daß diese auf einem Halbleiterchip integriert ist.

## Claims

1. Circuitry for monitoring temperature, comprising, in a semiconductor circuit, integrated power switching transistors (1-1, 1-2, ...), in which the switching circuit temperature is determined by temperature sensors for the purpose of their overload protection and a switching transistor turn-off takes place on exceeding a specified temperature value, one temperature sensor (2-1, 2-2, ...) being assigned in each case to one power switching transistor (1-1, 1-2, ...) in each case and the temperature sensor output signal being compared with a first reference (V_{REF1}) corresponding to a first predetermined temperature value and only the power switching transistor (1-1, 1-2, ...) assigned to it being turned off on reaching the first predetermined temperature value, characterized by, in each case, a comparison stage (3-1, 3-2, ...) coupled to one temperature sensor (2-1, 2-2, ...) in each case and by a logic circuit (6-1, 6-2, ..., 7) which is coupled to the comparison stages (3-1, 3-2, ...) and which, when the first predetermined temperature value is reached by a power switching transistor (for example 1-1) and it is turned off, switches over the comparison stages (3-2, ...) of all the other power switching transistors (1-2, ...) from the reference (V_{REF1}) corresponding to the first predetermined temperature value to a second reference (V_{REF2}) corresponding to a second predetermined temperature value which is higher than the first predetermined temperature value.

2. Circuitry according to Claim 1, characterized in that transistor stages which are connected as emitter followers and are connected to a third reference (V_{REF3}) are provided as temperature sensors (2-1, 2-2, ...).

3. Circuitry according to Claim 1 and/or 2, characterized in that the logic circuit (6-1, 6-2, ..., 7) is formed by, in each case, a gate stage (6-1, 6-2, ...) which is assigned to a power switching transistor (1-1, 1-2, ...) in each case and which comprises a first inverter (10-1, 10-2, ...) coupled to the output of the associated comparison stage (3-1, 3-2, ...), an AND gate (11-1, 11-2, ...) coupled by means of an input to the output of the first inverter (10-1, 10-2, ...), and a second inverter (12-1, 12-2, ...) coupled to the output of the AND gate (11-1, 11-2, ...), and by an OR gate (7) which is coupled to the output, in each case, of a comparison stage (3-1, 3-2, ...) by means, in each case, of an input and which is coupled to, in each case, a further input of the AND gate (11-1, 11-2, ...) of the gate stages (6-1, 6-2, ...) by means of its output.

4. Circuitry according to Claim 3, characterized in that the output of the second inverter (12-1, 12-2, ...) is coupled to, in each case, a first changeover switch (4-1, 4-2, ...) which couples the first reference (V_{REF1}) to the respective comparison stage (3-1, 3-2, ...) and the output of the AND gate (11-1, 11-2, ...) of the respective gate stage (6-1, 6-2, ...) is coupled to, in each case, a second changeover switch (5-1, 5-2, ...) which couples the second reference (V_{REF2}) to the respective comparison stage (3-1, 3-2, ...).

5. Circuitry according to one of the preceding claims, characterized in that it is integrated on a semiconductor chip.

## Revendications

1. Montage de contrôle de la température, comportant des transistors de commutation de puissance (1-1, 1-2, ...), qui sont intégrés dans un circuit à semiconducteurs, et dans lequel la température du circuit est détectée par des capteurs de température pour assurer la protection du montage contre une surcharge, et un blocage du transistor de commutation est exécuté lors du dépassement d'une valeur de température prédéterminée, dans lequel respectivement un capteur de température (2-1, 2-2, ...) est associé respectivement à un transistor de commutation de puissance (1-1, 1-2,...) et le signal de sortie du capteur de température est comparé à une première référence (V_{REF1}), qui correspond à une première valeur de température prédéterminée, et seul le transistor de commutation de puissance (1-1,1-2,...), qui est associé à cette référence, est bloqué lorsque la première valeur de température prédéterminée est atteinte, caractérisé par un étage comparateur (3-1,3-2,...), qui est accouplé respectivement à un capteur de température (2-1,2-2,...), et par une logique (6-1,6-2,...,7), qui est accouplée aux étages comparateurs (3-1,3-2,...) et qui, lorsque la première valeur de température prédéterminée est atteinte, réalise, au moyen d'un transistor de commutation de puissance (par exemple 1-1) et de son blocage, une commutation des étages comparateurs (3-2,...) de tous les autres transistors de commutation de puissance (1-2,...) de la première référence (V_{REF1}), qui correspond à la première valeur de température prédéterminée, sur une seconde référence (V_{REF2}), qui correspond à une seconde valeur de température prédéterminée supérieure à la première valeur de température prédéterminée.

2. Montage suivant la revendication 1, caractérisé par le fait qu'il est prévu, comme capteurs de température (2-1, 2-2,...), des étages à transistors branchés en émetteurs suiveurs et reliés à une troisième référence (V_{REF3}).

3. Montage suivant la revendication 1 et/ou 2, caractérisé par le fait que la logique (6-1,6-2,...,7) est formé par
respectivement un étage à portes (6-1,6-2,...), qui est associé respectivement à un transistor de commutation de puissance (1-1,1-2,...),
qui comporte un premier inverseur (10-1,10-2,...), accouplé à l'entrée de l'étage comparateur associé (3-1,3-2,...), une porte ET (11-1,11-2,...) couplée à une entrée à la sortie du premier inverseur (10-1,10-2,...), ainsi qu'un second inverseur (12-1,12-2,...) couplé à la sortie de la porte ET (11-1,11-2,...), ainsi qu'une porte OU (7), qui est couplée respectivement par une entrée à la sortie respectivement d'un étage comparateur (3-1,3-2,...) et, par sa sortie, à respectivement une autre entrée de la porte ET (11-1,11-2,...) des étages à portes (6-1,6-2,...).

4. Montage suivant la revendication 3, caractérisé par le fait que la sortie du second inverseur (12-1,12-2,...) est couplée à respectivement un premier commutateur (4-1, 4-2,...), qui applique la première référence (V_{REF1}) à l'étage comparateur respectif (3-1,3-2,...), et que la sortie de la porte ET (11-1,11-2,...) de l'étage à portes (6-1,6-2,...) est couplée à respectivement un second commutateur (5-1,5-2,...), qui applique la seconde référence (V_{REF2}) au premier étage comparateur (3-1,3-2,...).

5. Montage suivant l'une des revendications précédentes, caractérisé par le fait qu'il est intégré sur une microplaquette à semiconducteurs.
